(19) Europäisches Patentamt
European Patent Office
Office européen des brevets

(11) **EP 2 556 594 B1**

(12) **EUROPEAN PATENT SPECIFICATION**

(45) Date of publication and mention
of the grant of the patent:
**12.08.2020   Bulletin 2020/33**

(21) Application number: **11766707.1**

(22) Date of filing: **07.04.2011**

(51) Int Cl.:
*H04B 3/00* *(2006.01)*        *H01B 12/02* *(2006.01)*
*B29C 35/08* *(2006.01)*      *B29C 35/10* *(2006.01)*
*B29C 71/02* *(2006.01)*

(86) International application number:
**PCT/US2011/031530**

(87) International publication number:
**WO 2011/127248 (13.10.2011 Gazette 2011/41)**

(54) **APPARATUS FOR CURING THIN FILMS ON A MOVING SUBSTRATE**

VORRICHTUNG ZUR HÄRTUNG VON DÜNNSCHICHTEN AUF EINEM BEWEGLICHEN SUBSTRAT

APPAREIL DE DURCISSEMENT DE COUCHES MINCES SUR SUBSTRAT EN MOUVEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **08.04.2010   US 321910 P**

(43) Date of publication of application:
**13.02.2013   Bulletin 2013/07**

(73) Proprietor: **NCC Nano, LLC
Dallas, TX 75251 (US)**

(72) Inventors:
• **JACKSON, Douglas, K.
Austin
TX 78665 (US)**
• **SCHRODER, Kurt, A.
Coupland
TX 78615 (US)**
• **MCCOOL, Steven, C.
Austin
TX 78728 (US)**

(74) Representative: **Mewburn Ellis LLP
Aurora Building
Counterslip
Bristol BS1 6BX (GB)**

(56) References cited:
**WO-A1-2010/005609      US-A- 3 065 290
US-A- 3 815 054         US-A- 3 815 054
US-A- 4 112 335         US-A- 6 049 042
US-A- 6 049 042         US-A1- 2009 181 184
US-A1- 2009 181 184     US-B1- 6 313 409
US-B1- 6 506 971        US-B1- 6 684 486**

## Description

## BACKGROUND OF THE INVENTION

### 1. Technical Field

The present invention relates to curing systems in general, and, in particular, to an apparatus for curing thin films on a low-temperature substrate according to claim 1.

### 2. Description of Related Art

Thermal processing of thin films is often limited by the properties of substrates. Since the cost of substrates can be a significant portion of the total cost of the final product, inexpensive substrates are generally preferred. Inexpensive substrates, such as polymer or cellulose, tend to have a lower maximum working temperature than the more expensive substrates such as glass or ceramic. Thus, when thermally processing a thin film on a low-temperature substrate, the entire substrate stack is typically heated to the maximum working temperature of the substrate to minimize processing time.

Some thin film materials require a higher level of thermal processing that is not compatible with low-temperature substrates. Solutions can come in the form of increased processing time or increased temperature. The former solution increases the cost by reducing throughput and still may be inadequate for many types of thin films. The latter solution generally requires the usage of a more expensive substrate capable of withstanding higher processing temperatures. Thus, both solutions are undesirable from an economic standpoint.

US 2009/181184 discloses a method for producing an electrically conductive thin film on a substrate according to the preamble of claim 1. Initially, a reducible metal compound and a reducing agent are dispersed in a liquid. The dispersion is then deposited on a substrate as a thin film. The thin film along with the substrate is subsequently exposed to a pulsed electromagnetic emission to chemically react with the reducible metal compound and the reducing agent such that the thin film becomes electrically conductive.

## SUMMARY OF THE INVENTION

In accordance with a preferred embodiment of the present invention, a curing apparatus includes a computer control system, a conveyance system, a flashlamp driver, and a flashlamp. The curing apparatus also includes a low-inductance cable, having an inductance of less than 100nH/m, connected between the flashlamp driver and the flashlamp. The low-inductance cable includes at least one liquid cooling line and multiple forward and return path wires interleaved in a regular hexagonal closed packed configuration such that every wire is adjacent to at least one cooling line and at least one wire of opposite polarity.

All features and advantages of the present invention will become apparent in the following detailed written description.

## BRIEF DESCRIPTION OF THE DRAWINGS

The invention itself, as well as a preferred mode of use, further objects, and advantages thereof, will best be understood by reference to the following detailed description of an illustrative embodiment when read in conjunction with the accompanying drawings, wherein:

Figure 1 is a diagram of a curing apparatus, in accordance with a preferred embodiment of the present invention;

Figure 2 is a block diagram of a flashlamp controller within the curing apparatus from Figure 1;

Figure 3a is a cross-sectional diagram of a basic cable unit of a low-inductance cable within the curing apparatus from Figure 1, in accordance with a preferred embodiment of the present invention; and

Figure 3b-3d are cross-sectional diagrams of low-inductance cables formed by the basic cable unit from Figure 3a, in accordance with a preferred embodiment of the present invention.

## DETAILED DESCRIPTION OF A PREFERRED EMBODIMENT

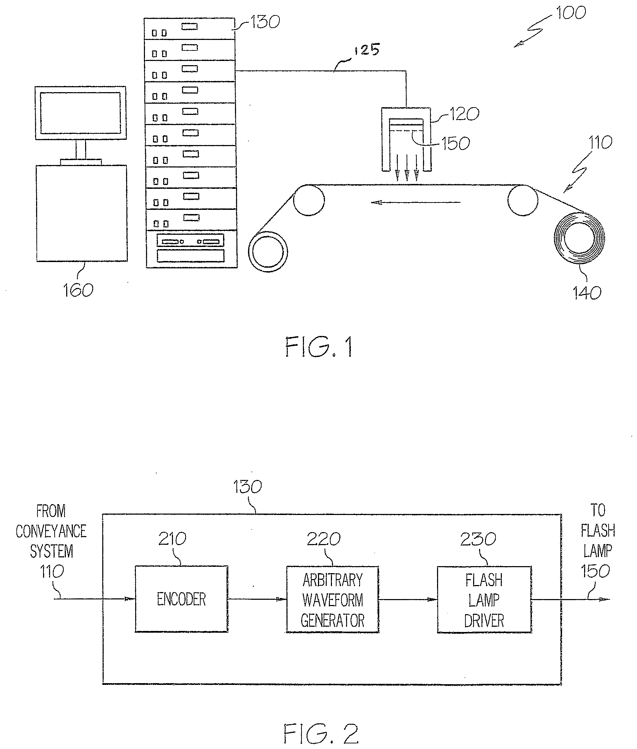

Referring now to the drawings and in particular to Figure 1, there is depicted a diagram of a curing apparatus, in accordance with a preferred embodiment of the present invention. As shown, a curing apparatus 100 includes a conveyance system 110, a flashlamp head 120 having a flashlamp 150 and a flashlamp controller 130. A low inductance cable 125 is connected between flashlamp controller 130 and the flashlamp head 120. Conveyance system 110 moves a thin film stack 140 past flashlamp head 120 while flashlamp controller 130 provides shaped pulses of current to flashlamp 150 using pulse width modulation (PWM) such that the shaped pulses are synchronized to the conveyance speed of thin films on conveyance system 110. Thin film stack 140 includes thin film deposited on a low-temperature substrate such as polymer or paper. Preferably, flashlamp 150 is a sealed flash lamp filled with gases such as xenon, krypton or argon. Flashlamp 150 can also be a water-wall flashlamp, sometimes referred to as a Directed Plasma Arc (DPA) lamp.

A computer control system 160 is utilized to control the functionalities of flashlamp controller 130. Computer control system 160 preferably includes a processing unit, input devices such as a keyboard, a mouse, a touchscreen, etc., and output devices such as a monitor, as they are well-known to those skilled in the art.

With reference now to Figure **2**, there is depicted a block diagram of flashlamp controller **130**. As shown, flashlamp controller **130** includes an encoder **210**, an arbitrary waveform generator **220** and a flashlamp driver **230**. After receiving inputs, such as conveyance speed, from conveyance system **110** (from Figure **1**), encoder **210** provides trigger signals to arbitrary waveform generator **220** at appropriate times for curing thin films located on conveyance system **110**. With the trigger signals, arbitrary waveform generator **220** is able to generate waveforms of various shapes and timing based on user inputs. Arbitrary waveform generator **220** sends waveform signals to flashlamp driver **230** that amplifies the waveform signals for driving flashlamp **150** (from Figure **1**).

In order to change the shape of a pulse train emitted by a flashlamp system in response to an input in real time to affect the thermal gradient created in a moving thin film stack, the power to flashlamp **150** is preferably pulse-width modulated. In order to perform PWM, a low-inductance (at least less than 100nH/m and preferably less than 50nH/m) cable is needed to transmit the power from flashlamp drivers **230** to flashlamp **150**. Additionally, the low-inductance cable should be water-cooled but light enough for a person to pick up and have a minimum bending radius of less than 0.30 m (1 foot) so that that it can be integrated into a factory environment.

Theoretically, the inductance of an optimized off-the-shelf coaxial cable could be low enough for the present application but it is difficult to fabricate, since coaxial end connectors must be soldered to the inner and outer conductors in a water-tight assembly. Additionally, both the inductance and bend radius of off-the-shelf coaxial cables are larger than preferred.

Twisted pair cable has an inductance that is marginal for the present application. Additionally, the nature of the twisting in twisted pair cables makes them difficult to provide reliable cooling to the individual wires. Since the wires are twisted, they are inefficiently packed when bundled together making the outer diameter larger and therefore bend radius larger than desired. Ribbon cable, which consists of alternating forward and return path wires has an inductance that is too high for the present application.

Low-inductance cable **125**, which can be referred to as a Low-Inductance Multi-Strand (LIMS) cable, includes multiple forward wires, return wires, and cooling lines, all interleaved with each other forming a hexagonal closed pack pattern. LIMS cable **125** has an extremely low inductance (~16 nH/m). LIMS cable **125** adds less than 200 nH of inductance to the entire system. LIMS cable **125** can handle up to 20 kA of current with a peak power deliver greater than 10 MW and an average power deliver of greater than 10 kW. The diameter of LIMS cable **125** is preferably less than 5.0 cm, and LIMS cable **125** can be bent about a small (less than 0.3 m) radius.

In order to pulse-width modulate a pulse train of a given total duration, each individual pulse, *i.e.,* a micropulse, needs to be much shorter than the pulse train in order to provide pulse shaping. Furthermore, the pulses need to be more intense than a source providing a single pulse of the same length as the pulse train as the PWM system is not turned on for a portion of the time. Thus, curing apparatus **110** is capable of providing pulse lengths as short as 10 microseconds with peak power in excess of 100 kW/cm$^2$. In addition, the PWM frequency for pulses is as fast as 50 kHz.

Each pulse train includes at least two micropulses that form a shaped pulse. Shaping a pulse allows the temperature profile in thin film stack **150** to be customized for an optimal cure. In its simplest form, a shaped pulse, which includes uniform micropulses, has six variables or control parameters: intensity (voltage), pulse length, the average number of shaped pulses that impinged on the substrate in any given area on a film stack, pulse repetition frequency, number of micropulses within a shaped pulse, and duty cycle of micropulses. When the micropulses are not uniform, the duration and delay of each micropulse should also be specified. This allows the formation of an arbitrarily shaped pulse. The control parameters are initially entered into a thermal simulation, and these parameters are subsequently used as inputs to flashlamp controller **130**.

When the inductance of the entire pulsed power delivery system is less than about 2 $\mu$H, the rise time of the emission from flashlamp **150** becomes limited by the rate that the plasma can be resistively heated by the current passing though flashlamp **150**. Likewise, the fall rate of the emission from flashlamp **150** becomes limited by the radiation cooling rate of the plasma in flashlamp **150**. When the inductance of the entire pulsed power delivery system is greater than about 2 $\mu$H, the inductance begins to increase the minimum rise and fall rate of the emission, thus limiting the frequency at which the emission can be pulsed-width modulated. The pulsed power delivery system in the present invention has a total inductance of about 1.2 $\mu$H, of which about 0.2 mH is from LIMS cable **125**, meaning that the maximum PWM is not limited by inductance. LIMS cable **125** for curing apparatus **100** preferably has the following requirements:

1. low inductance per unit length (less than 50 nH/m);
2. low resistance per unit length (less than 1.0 m$\Omega$/m);
3. long length (up to 10 meters);
4. moderate voltage rating (up to about 1,200 V)
5. active liquid cooling;
6. high current capacity (up to about 20 kA); and
7. small bend radius (less than 0.3 m) for handling.

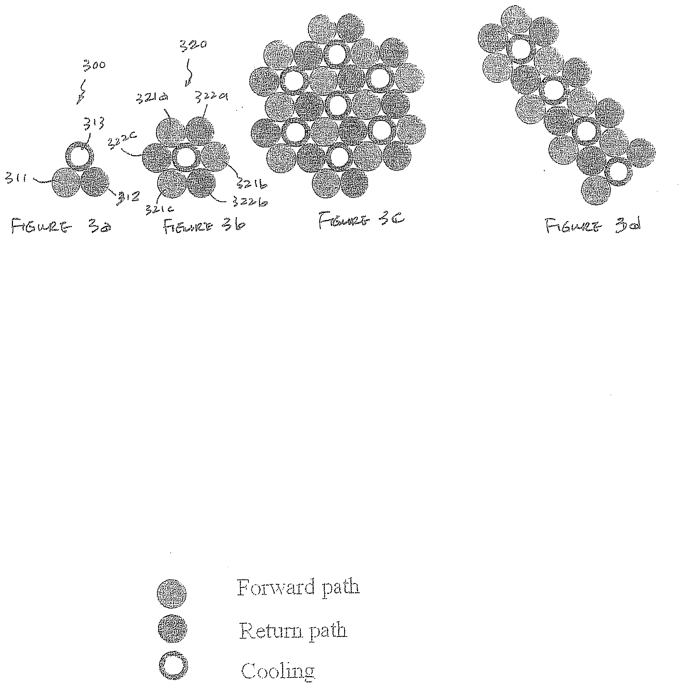

Referring now to Figure **3a**, there is illustrated a cross-sectional diagram of a basic cable unit for forming LIMS cable **125**, in accordance with a preferred embodiment of the present invention. As shown, a basic cable unit **300** includes a cooling channel **313**, a forward-path cable **311** and a return-path cable **312**. Preferably, forward-path cable **311** and return-path cable **312** are made of copper.

Figure **3b** shows that a three-pair round cable can be formed by combining several basic cable units **300**. As shown, a three-pair round cable **320** includes forward-path cables **321a-321c** and return-path cables **322a-322c** formed around a cooling channel **323**. In addition, forward path cables **321a-321c** are interleave with and coupled to return path cables **322a-322c.**

In order to change the shape of a pulse train emitted by flashlamp **150** in response to an input in real time to affect the thermal gradient created in a moving thin film stack cure materials on moving substrates at speeds up to 300 meters per minute, a low-inductance, water-cooled cable assembly, such as a twelve-pair round LIMS cable **330** shown in Figure **3c** and/or an eight-pair flat LIMS cable **340** shown in Figure **3d,** is essential to provide precise temporal control.

When the substrate is moving, and the shaped-pulse frequency of flashlamp **150** is synchronized to the conveyance speed, the frequency is given by

$$ F = \frac{1.67 \times S \times O}{W} $$

*where*

f = flashlamp shaped-pulse rate [Hz]
S = web speed [m/min]
O = overlap factor (*i.e.,* the average number of flashlamp pulses received by substrate at any given point)
W = curing head width in the conveyance direction [cm]

For example, with a conveyance speed of 100 m/min, and overlap factor of 4, and a curing head width of 7 cm, the shaped-pulse rate of the strobe is 95.4 Hz.

Since the flash rate of flashlamp **150** is synchronized to the substrate conveyance speed, small changes in the speed do not appreciably change the cure of thin films.

The 8 variables of the power delivery system to flashlamp **150** can be changed continuously and on the fly. This allows the curing parameters to adapt in real time to a change in the film or substrate in response from sensor data before or after cure. These two qualities produce a cured film with optimized and consistent results and has dramatically higher yield than the prior art which requires the system to be powered down for minutes to change any pulse characteristics. Furthermore, the pulse characteristics can be changed continuously to within about 0.1% resolution, which results in a much tighter optimization control of the curing. The prior art had discrete changes.

As has been described, the present invention provides a curing apparatus for curing thin films on a moving substrate.

While the invention has been particularly shown and described with reference to a preferred embodiment, it will be understood by those skilled in the art that various changes in form and detail may be made therein without departing from the scope of the invention, as defined in the claims below.

**Claims**

1. An apparatus (100) for curing a thin film on a moving substrate, said apparatus (100) comprising:

   a conveyance system (110) for moving a layer of thin film mounted on a substrate;
   a flashlamp (150) for providing electromagnetic pulses to said thin film while said thin film is being moved in relation to said flashlamp (150);
   a flashlamp controller (130) for modulating pulse widths of said electromagnetic pulses; and **characterized by**
   a low-inductance cable (125) connected between said flashlamp (150) and said flashlamp controller (130);
   wherein said low-inductance cable (125) has an inductance of less than 100 nH/m, and includes:

      a cooling core (313);
      a plurality of return-path cables (312) coupled to said cooling core (313); and
      a plurality of forward-path cables (311) coupled to said cooling core (313), wherein said forward-path cables (311) are interleavely coupled to said return-path cables (312).

2. The apparatus of Claim 1, wherein said cooling core (313), said return-path cables (312) and said forward-path cables (311) are interleaved in a hexagonal closed packed configuration.

3. The apparatus of Claim 1, wherein one of said return-path cables (312) is adjacent to a cooling core (313) and one of said forward-path cables (311).

4. The apparatus of Claim 1, wherein one of said forward-path cables (311) is adjacent to a cooling core (313) and one of said return-path cables (312)d.

5. The apparatus of any preceding claim, wherein the cooling core (313) of the low-inductance cable (125) is arranged to receive water as a coolant.

6. The apparatus of any preceding claim, wherein the low-inductance cable (125) has a minimum bending radius which is less than 0.3 metres.

**Patentansprüche**

1. Vorrichtung (100) zum Härten eines Dünnfilms auf einem sich bewegenden Substrat, wobei die Vorrichtung (100) Folgendes umfasst:

   ein Fördersystem (110) zum Bewegen einer Schicht eines Dünnfilms, der auf einem Substrat aufgebracht ist;
   eine Blitzlichtlampe (150) zum Bereitstellen elektromagnetischer Impulse an dem Dünnfilm, während der Dünnfilm relativ zur Blitzlichtlampe (150) bewegt wird;
   eine Blitzlichtlampensteuereinheit (130) zum Modulieren von Impulsbreiten der elektromagnetischen Impulse; und **dadurch gekennzeichnet, dass**:

   ein Niederinduktivitätskabel (125) zwischen der Blitzlichtlampe (150) und der Blitzlichtlampensteuereinheit (130) geschaltet ist;
   wobei das Niederinduktivitätskabel (125) eine Induktivität von weniger als 100 nH/m aufweist, und Folgendes umfasst:

   einen Kühlkern (313);
   eine Vielzahl von Rückleitungskabeln (312), die mit dem Kühlkern (313) gekoppelt sind; und
   eine Vielzahl von Vorwärtsleitungskabeln (311), die mit dem Kühlkern (313) gekoppelt sind, wobei die Vorwärtsleitungskabel (311) mit den Rückleitungskabeln (312) verschachtelt gekoppelt sind.

2. Vorrichtung nach Anspruch 1, wobei der Kühlkern (313), die Rückleitungskabel (312) und die Vorwärtsleitungskabel (311) in einer hexagonalen, geschlossenen, gepackten Konfiguration verschachtelt sind.

3. Vorrichtung nach Anspruch 1, wobei eines der Rückleitungskabel (312) benachbart zu einem Kühlkern (313) und einem der Vorwärtsleitungskabel (311) angeordnet ist.

4. Vorrichtung nach Anspruch 1, wobei eines der Vorwärtsleitungskabel (311) benachbart zu einem Kühlkern (313) und einem der Rückleitungskabel (312) angeordnet ist.

5. Vorrichtung nach einem der vorangegangenen Ansprüche, wobei der Kühlkern (313) des Niederinduktivitätskabels (125) so angeordnet ist, dass es Wasser als Kühlmittel aufnimmt.

6. Vorrichtung nach einem der vorangegangenen Ansprüche, wobei das Niederinduktivitätskabel (125) einen Mindestkrümmungsradius aufweist, der kleiner ist als 0,3 m.

**Revendications**

1. Appareil (100) pour durcir un film mince sur un substrat en mouvement, ledit appareil (100) comprenant :

   un système de transport (110) pour déplacer une couche de film mince montée sur un substrat ;
   une lampe flash (150) pour fournir des impulsions électromagnétiques audit film mince pendant que ledit film mince est déplacé par rapport à ladite lampe flash (150) ;
   un dispositif de commande de lampe flash (130) pour moduler des largeurs d'impulsion desdites impulsions électromagnétiques ; et **caractérisé par**
   un câble à faible inductance (125) connecté entre ladite lampe flash (150) et ledit dispositif de commande de lampe flash (130) ;
   dans lequel ledit câble à faible inductance (125) a une inductance de moins de 100 nH/m, et comprend :

   un noyau de refroidissement (313) ;
   une pluralité de câbles de trajet de retour (312) couplés audit noyau de refroidissement (313) ; et
   une pluralité de câbles de trajet aller (311) couplés audit noyau de refroidissement (313), dans lequel lesdits câbles de trajet aller (311) sont couplés de manière entrelacée auxdits câbles de trajet de retour (312).

2. Appareil selon la revendication 1, dans lequel ledit noyau de refroidissement (313), lesdits câbles de trajet de retour (312) et lesdits câbles de trajet aller (311) sont entrelacés selon une configuration hexagonale conditionnée fermée.

3. Appareil selon la revendication 1, dans lequel l'un desdits câbles de trajet de retour (312) est adjacent à un noyau de refroidissement (313) et à l'un desdits câbles de trajet aller (311).

4. Appareil selon la revendication 1, dans lequel l'un desdits câbles de trajet aller (311) est adjacent à un noyau de refroidissement (313) et à l'un desdits câbles de trajet de retour (312)d.

5. Appareil selon l'une quelconque des revendications précédentes, dans lequel le noyau de refroidissement (313) du câble à faible inductance (125) est conçu pour recevoir de l'eau comme réfrigérant.

**6.** Appareil selon l'une quelconque des revendications précédentes, dans lequel le câble à faible inductance (125) a un rayon de courbure minimum qui est inférieur à 0,3 mètre.

FIG. 1

FIG. 2

300

320

313

321a    322a

322c

311

312    321c    322b    322b

321c

FIGURE 3a    FIGURE 3b    FIGURE 3c    FIGURE 3d

Forward path

Return path

Cooling

**EP 2 556 594 B1**

## REFERENCES CITED IN THE DESCRIPTION

**Patent documents cited in the description**

- US 2009181184 A